# EUROPÄISCHE PATENTANMELDUNG

(11) **EP 4 806 330 A1**
(43) Veröffentlichungstag der Anmeldung: **16.09.2026**
(21) Anmeldenummer: 26159009.5
(22) Anmeldetag: 17.02.2026
(51) Int. Cl.: A47L 15/42, F24C 7/08, H03K 17/96, G06F 3/042

(54) **BEDIENVORRICHTUNG FÜR EIN HAUSHALTSGERÄT**

(30) Priorität: 12.03.2025 LU 600536
(71) Anmelder: Miele & Cie. KG, 33332 Gütersloh (DE)
(72) Erfinder: Schneider, Daniel, 33415 Verl (DE)

(57) **Zusammenfassung**

Die Erfindung betrifft eine Bedienvorrichtung (2) für ein Haushaltsgerät (4), wobei die Bedienvorrichtung (2) als eine berührungslose Bedienvorrichtung mit mindestens einer optischen Sendeeinheit (6) zur Emission einer optischen Detektionsstrahlung, mindestens einer optischen Empfangseinheit (8) zum Empfang einer optischen Reflektionsstrahlung in Abhängigkeit einer Reflektion der Detektionsstrahlung an einem Benutzer (10) und mindestens einer mit der mindestens einen Sendeeinheit (6) und der mindestens einen Empfangseinheit (8) signalübertragend verbundenen Elektronikeinheit (12) zur Erzeugung der Detektionsstrahlung und zur Auswertung der Reflektionsstrahlung ausgebildet ist, dadurch gekennzeichnet, dass die Bedienvorrichtung (2) derart ausgebildet ist, dass die Bedienvorrichtung (2) durch einen Spalt (14) zwischen zwei Bauteilen des Haushaltsgeräts oder zwischen einerseits dem Haushaltsgerät (4) und andererseits einem direkt zu dem Haushaltsgerät (4) benachbarten Nachbarbauteil (16) einer baulichen Umgebung des Haushaltsgeräts (4) von dem Benutzer (10) benutzbar ist, wobei der Spalt (14) eine Spaltbreite von kleiner oder gleich 3 cm aufweist.

## Beschreibung

Die Erfindung betrifft eine Bedienvorrichtung für ein Haushaltsgerät der im Oberbegriff des Patentanspruchs 1 genannten Art.

Derartige Bedienvorrichtungen für Haushaltsgeräte sind aus dem Stand der Technik in einer Vielzahl von Ausführungsformen vorbekannt. Die bekannten Bedienvorrichtungen für Haushaltsgeräte sind als eine berührungslose Bedienvorrichtung mit mindestens einer optischen Sendeeinheit zur Emission einer optischen Detektionsstrahlung, mindestens einer optischen Empfangseinheit zum Empfang einer optischen Reflektionsstrahlung in Abhängigkeit einer Reflektion der Detektionsstrahlung an einem Benutzer und mindestens einer mit der mindestens einen Sendeeinheit und der mindestens einen Empfangseinheit signalübertragend verbundenen Elektronikeinheit zur Erzeugung der Detektionsstrahlung und zur Auswertung der Reflektionsstrahlung ausgebildet.

Der Erfindung stellt sich somit das Problem, eine Bedienvorrichtung für ein Haushaltsgerät zu verbessern.

Erfindungsgemäß wird dieses Problem durch eine Bedienvorrichtung für ein Haushaltsgerät mit den Merkmalen des Patentanspruchs 1 gelöst, die dadurch gekennzeichnet ist, dass die Bedienvorrichtung derart ausgebildet ist, dass die Bedienvorrichtung durch einen Spalt zwischen zwei Bauteilen des Haushaltsgeräts oder zwischen einerseits dem Haushaltsgerät und andererseits einem direkt zu dem Haushaltsgerät benachbarten Nachbarbauteil einer baulichen Umgebung des Haushaltsgeräts von dem Benutzer benutzbar ist, wobei der Spalt bevorzugt eine Spaltbreite von kleiner oder gleich 3 cm aufweist. Vorteilhafte Ausgestaltungen und Weiterbildungen der Erfindung ergeben sich aus den nachfolgenden Unteransprüchen.

Der mit der Erfindung erreichbare Vorteil besteht insbesondere darin, dass eine Bedienvorrichtung für ein Haushaltsgerät verbessert ist. Aufgrund der erfindungsgemäßen Ausbildung der Bedienvorrichtung ist eine einfache Interaktion des Benutzers mit dem die erfindungsgemäße Bedienvorrichtung aufweisenden Haushaltsgerät auf konstruktiv und fertigungstechnisch sehr einfache Art und Weise ermöglicht. Die erfindungsgemäße Bedienvorrichtung ist für einen sehr platzsparenden Einsatz geeignet ausgebildet, so dass naturgemäß vorhandene Fugen des mit der erfindungsgemäßen Bedienvorrichtung ausgestatteten Haushaltsgeräts oder zwischen dem mit der erfindungsgemäßen Bedienvorrichtung ausgestatteten Haushaltsgerät und angrenzenden Nachbarbauteilen, beispielsweise von Möbelteilen wie Arbeitsplatten oder dergleichen, für eine Bedienung des Haushaltsgeräts nutzbar sind. Ferner lässt sich die erfindungsgemäße Bedienvorrichtung in unterschiedlichen Einbausituationen, wie zum Beispiel Möbel- oder Küchenumgebungen, ohne eine individuelle Anpassung von Möbel- oder Anbauteilen integrieren. Um den Benutzer nicht hinsichtlich der Wahl seiner bevorzugten Möbelfronten oder deren charakteristischen Eigenschaften, beispielsweise Materialien und Beschichtungen, einzuschränken, ist die erfindungsgemäße Bedienvorrichtung und damit das damit umsetzbare Bedienkonzept vollkommen unabhängig von den vorgenannten Rahmenbedingungen und Wünschen des Benutzers einsetzbar. Auch lässt sich die erfindungsgemäße Bedienvorrichtung leicht in bereits vorhandene Aufbaukonzepte von Haushaltsgeräten integrieren, so dass auch bestehende Haushaltsgerätekonstruktionen ohne viel Aufwand in Konstruktion und Fertigung auf eine erfindungsgemäße Bedienvorrichtung umrüstbar sind.

Grundsätzlich ist die erfindungsgemäße Bedienvorrichtung für ein Haushaltsgerät nach Art, Funktionsweise, Material, Anordnung und Dimensionierung in weiten geeigneten Grenzen frei wählbar. Ferner ist die erfindungsgemäße Bedienvorrichtung für ein Haushaltsgerät auch bei gewerblichen Geräten, also Geräten für den professionellen Einsatz, vorteilhaft einsetzbar.

Eine vorteilhafte Weiterbildung der erfindungsgemäßen Bedienvorrichtung sieht vor, dass der Spalt eine Spaltbreite von kleiner oder gleich 5 mm, bevorzugt von kleiner oder gleich 1 mm, besonders bevorzugt von kleiner oder gleich 0,5 mm aufweist. Die erfindungsgemäße Bedienvorrichtung ist hier also derart ausgebildet, dass diese durch einen derartigen Spalt zwischen zwei Bauteilen des Haushaltsgeräts oder zwischen einerseits dem Haushaltsgerät und andererseits einem direkt zu dem Haushaltsgerät benachbarten Nachbarbauteil einer baulichen Umgebung des Haushaltsgeräts von dem Benutzer benutzbar ist. Auf diese Weise sind auch sehr schmale Fugen für die erfindungsgemäße Bedienvorrichtung nutzbar. Entsprechend lässt sich das äußere Erscheinungsbild des mit der erfindungsgemäßen Bedienvorrichtung ausgestatteten Haushaltsgeräts in dessen Einbauumgebung, ohne funktionale Einbußen bei der Nutzung der erfindungsgemäßen Bedienvorrichtung, wesentlich verbessern. Dies gilt besonders für die bevorzugte und insbesondere für die besonders bevorzugte Ausführungsform dieser Weiterbildung.

Eine weitere vorteilhafte Weiterbildung der erfindungsgemäßen Bedienvorrichtung sieht vor, dass die Bedienvorrichtung zumindest teilweise als ein Teil des Haushaltsgeräts, bevorzugt vollständig als ein Teil des Haushaltsgeräts, ausgebildet ist. Hierdurch ist die erfindungsgemäße Bedienvorrichtung zumindest teilweise, bevorzugt vollständig, in das mit der erfindungsgemäßen Bedienvorrichtung funktional zusammenwirkende Haushaltsgerät baulich integriert. Entsprechend ist beispielsweise die Handhabung, insbesondere vor Ort bei dem Einbau des Haushaltsgeräts, wesentlich vereinfacht. Gleichzeitig ist die Funktionalität der erfindungsgemäßen Bedienvorrichtung durch diesen Einbau vor Ort, trotz der vereinfachten Handhabung, nicht beeinträchtigt. Dies gilt umso mehr, je größer der Integrationsgrad der erfindungsgemäßen Bedienvorrichtung in das Haushaltsgerät ist.

Eine besonders vorteilhafte Weiterbildung der erfindungsgemäßen Bedienvorrichtung sieht vor, dass die Bedienvorrichtung zusätzlich mindestens einen mit der mindestens einen Sendeeinheit und der mindestens einen Empfangseinheit signalübertragend verbundenen benutzerseitigen Lichtleiter aufweist, bevorzugt, dass der mindestens eine benutzerseitige Lichtleiter mindestens ein Lichtumlenkungselement aufweist, besonders bevorzugt, dass dieses Lichtumlenkungselement als ein integraler Bestandteil dieses benutzerseitigen Lichtleiters ausgebildet ist. Auf diese Weise ist die Flexibilität beispielsweise in der Anordnung der erfindungsgemäßen Bedienvorrichtung und von deren einzelnen Komponenten wesentlich verbessert. Dies gilt besonders für die bevorzugte Ausführungsform dieser Weiterbildung. Die besonders bevorzugte Ausführungsform dieser Weiterbildung hat darüber hinaus den weiteren Vorteil, dass eine sehr kompakte und damit platzsparende Lichtumlenkung auf konstruktiv und fertigungstechnisch sehr einfache Art ermöglicht ist. Hinsichtlich der Materialstärke für sehr flache Lichtleiter kommen zum Beispiel Lichtleiter mit folienähnlichen Strukturen, für eine Materialstärke von 100 µm bis 1000 µm, oder auf Basis flacher Kunststoffteile, für eine Materialstärke von 1 mm bis 8 mm, in Frage.

Eine vorteilhafte Weiterbildung der vorgenannten Weiterbildung der erfindungsgemäßen Bedienvorrichtung, rückbezogen auf Anspruch 3, sieht vor, dass jedem benutzerseitigen Lichtleiter ein von diesem benutzerseitigen Lichtleiter separater geräteseitiger Lichtleiter der Bedienvorrichtung zwecks Emission der Detektionsstrahlung und Empfang der Reflektionsstrahlung mittels der in dem Haushaltsgerät integrierten Elektronikeinheit funktional zugeordnet ist, wobei dieser geräteseitige Lichtleiter an oder in dem Haushaltsgerät angeordnet ist. Hierdurch ist zum Beispiel die vorgenannte Flexibilität in der räumlichen Anordnung der erfindungsgemäßen Bedienvorrichtung zusätzlich gesteigert. Ferner ist es möglich, die Lichtweiterleitung von der jeweiligen Sendeeinheit zu dem korrespondierenden benutzerseitigen Lichtleiter und von diesem zu der korrespondierenden Empfangseinheit und umgekehrt beispielsweise unabhängig von anderen Lichtwegen, also optischen Signalwegen, des mit der erfindungsgemäßen Bedienvorrichtung zumindest teilweise ausgestatteten Haushaltsgeräts, zum Beispiel unabhängig von Anzeigevorrichtungen wie Displays des Haushaltsgeräts, zu realisieren.

Eine vorteilhafte Weiterbildung der erfindungsgemäßen Bedienvorrichtung nach Anspruch 4 oder 5 sieht vor, dass die Bedienvorrichtung in Signalübertragungsrichtung zwischen der in dem Haushaltsgerät integrierten Elektronikeinheit und dem mindestens einen benutzerseitigen Lichtleiter zusätzlich ein für die Detektionsstrahlung und die Reflektionsstrahlung durchlässiges Fenster des Haushaltsgeräts aufweist, bevorzugt, dass das Fenster an einer Tür des Haushaltsgeräts zur Beladung und Entladung des Haushaltsgerät angeordnet ist und/oder, dass das Fenster gleichzeitig für eine Anzeigevorrichtung des Haushaltsgeräts zur optischen Anzeige von Haushaltsgeräteinformationen geeignet ausgebildet ist. Auf diese Weise ist eine in ästhetischer Hinsicht sehr vorteilhafte Integration der erfindungsgemäßen Bedienvorrichtung in das Haushaltsgerät ermöglicht. Entsprechend lässt sich die erfindungsgemäße Bedienvorrichtung für den Benutzer, beispielsweise mittels im Wesentlichen blickdichter Blenden oder Blendenabschnitte, weitgehend unsichtbar anordnen. Die erste Alternative der bevorzugten Ausführungsform dieser Weiterbildung hat ferner den Vorteil, dass einerseits ein Lichtweg, also ein Signalweg, für die Funktion der erfindungsgemäßen Bedienvorrichtung und damit der konstruktive und fertigungstechnische Aufwand bei der Realisierung der erfindungsgemäßen Bedienvorrichtung sehr reduzierbar ist. Andererseits ist hiermit zum Beispiel die Möglichkeit eröffnet, die erfindungsgemäße Bedienvorrichtung nicht nur in einem Schließzustand der Tür, sondern auch in einem Öffnungszustand der Tür nutzen zu können, wobei der vorgenannte Öffnungszustand technisch auf eine Spaltöffnung der Tür begrenzt ist. Die zweite Alternative der bevorzugten Ausführungsform dieser Weiterbildung hat alternativ oder zusätzlich dazu den Vorteil, dass das vorgenannte Fenster nicht als ein separates Fenster ausgebildet sein muss, sondern ein für einen anderen Zweck bei dem Haushaltsgerät vorgesehenes Fenster gleichzeitig für die erfindungsgemäße Bedienvorrichtung nutzbar ist.

Eine besonders vorteilhafte Weiterbildung der erfindungsgemäßen Bedienvorrichtung nach einem der Ansprüche 4 bis 6 sieht vor, dass die Bedienvorrichtung eine Mehrzahl von optischen Sendeeinheiten, von optischen Empfangseinheiten und a) von benutzerseitigen Lichtleitern oder b) von benutzerseitigen und von geräteseitigen Lichtleitern aufweist, wobei die Bedienvorrichtung derart ausgebildet ist, dass mittels der Bedienvorrichtung eine Geste des Benutzers detektierbar und auswertbar ist. Hierdurch sind auch komplexere Bedienvorgänge des Benutzers, beispielsweise mittels einer Hand oder eines Fingers des Benutzers, ermöglicht.

Eine vorteilhafte Weiterbildung der vorgenannten Weiterbildung der erfindungsgemäßen Bedienvorrichtung sieht vor, dass diese Mehrzahl von a) benutzerseitigen oder b) einerseits von benutzerseitigen und andererseits von geräteseitigen Lichtleitern baulich jeweils als ein einziges Bauteil oder als jeweils einzelne in oder auf einem Trägerbauteil der Bedienvorrichtung angeordnete a) benutzerseitige oder b) einerseits benutzerseitige und andererseits geräteseitige Lichtleiter ausgebildet ist, bevorzugt, dass das jeweilige Trägerbauteil gleichzeitig zur optischen Trennung der einzelnen a) benutzerseitigen oder b) einerseits der einzelnen benutzerseitigen und andererseits der einzelnen geräteseitigen Lichtleiter voneinander ausgebildet ist. Auf diese Weise ist die erfindungsgemäße Bedienvorrichtung gemäß der vorgenannten Weiterbildung auf konstruktiv und fertigungstechnisch sehr einfache Art umsetzbar, da hiermit zum Beispiel die Handhabung der erfindungsgemäßen Bedienvorrichtung bei der Montage wesentlich vereinfacht ist. Die bevorzugte Ausführungsform hat ferner den weiteren Vorteil, dass die Funktionalität des Trägerbauteils erhöht ist und dadurch weniger Bauteile und weniger Montagearbeiten erforderlich sind. Die vorgenannte optische Trennung ist meistens notwendig, um die ordnungsgemäße Funktion der erfindungsgemäßen Bedienvorrichtung zu gewährleisten. Anderenfalls besteht die Gefahr, dass mittels einer der Empfangseinheiten ein Signal detektierbar ist, ohne dass sich ein reflektierendes Objekt, also der Benutzer, in einem dieser Empfangseinheit zugeordneten Erfassungsbereich befindet. Man spricht hierbei auch von einem sogenannten Crosstalk.

Eine vorteilhafte Weiterbildung der beiden letztgenannten Weiterbildungen der erfindungsgemäßen Bedienvorrichtung sieht vor, dass jedem a) benutzerseitigen oder b) benutzerseitigen und geräteseitigen Lichtleiter entweder eine Sendeeinheit oder eine Empfangseinheit funktional zugeordnet ist, wobei die zu den Sendeeinheiten korrespondierenden Lichtleiter und die zu den Empfangseinheiten korrespondierenden Lichtleiter alternierend aufeinander folgend nebeneinander angeordnet sind, bevorzugt, dass direkt nebeneinander angeordnete Lichtleiter ein Sende-/Empfangs-Funktionspaar der Bedienvorrichtung ausbilden, besonders bevorzugt, dass eine gleiche Anzahl von Sende- und Empfangseinheiten derart nebeneinander angeordnet sind. Hierdurch ist eine für die Funktion einer derartigen erfindungsgemäßen Bedienvorrichtung sehr vorteilhafte Anordnung angegeben. Dies gilt besonders für die bevorzugte und insbesondere für die besonders bevorzugte Ausführungsform dieser Weiterbildung.

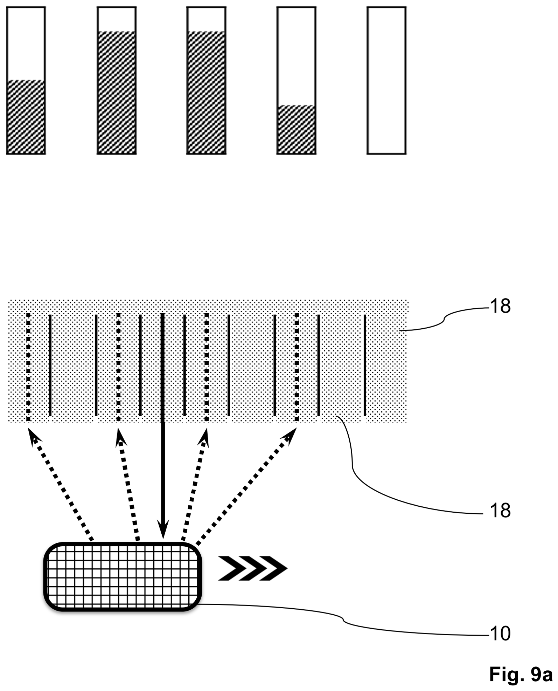

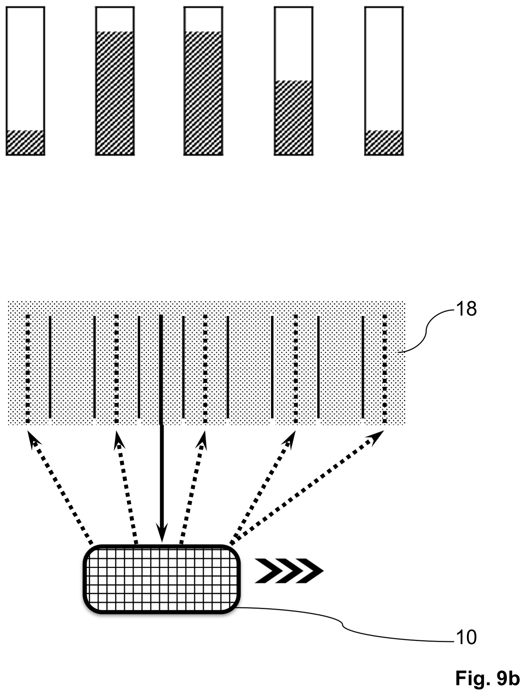

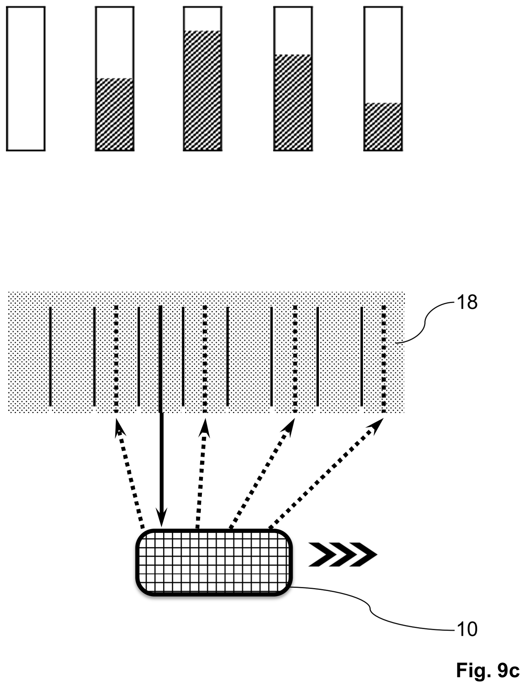

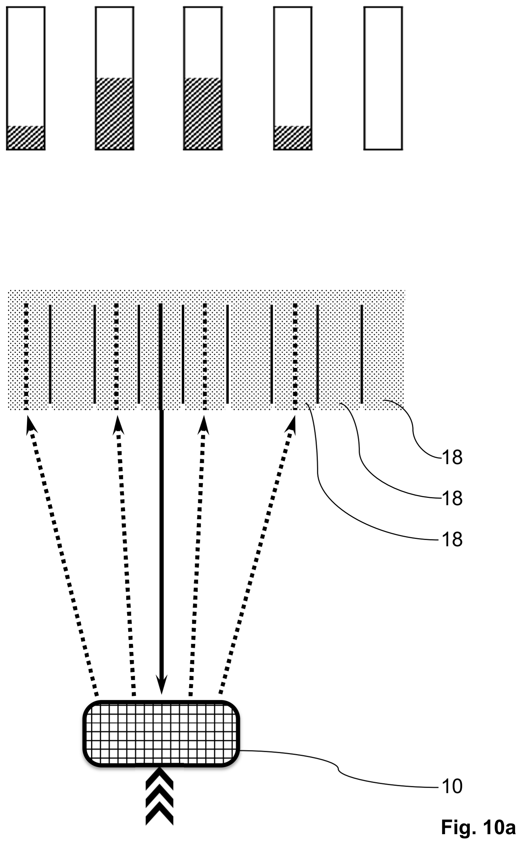

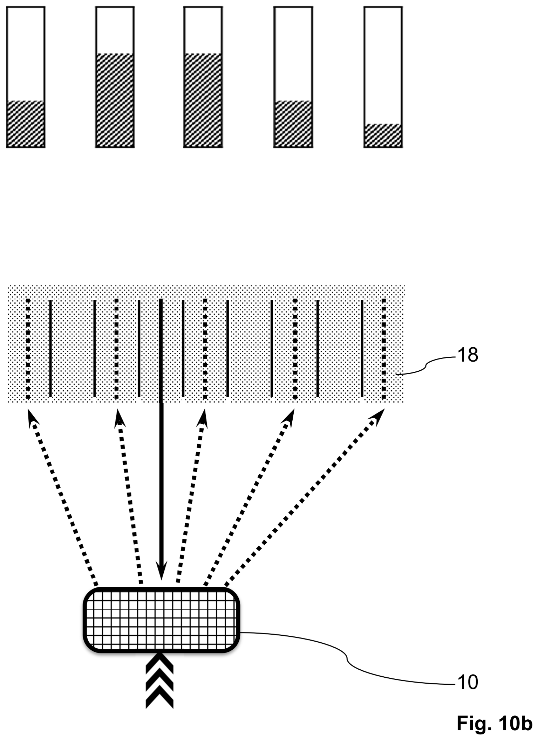

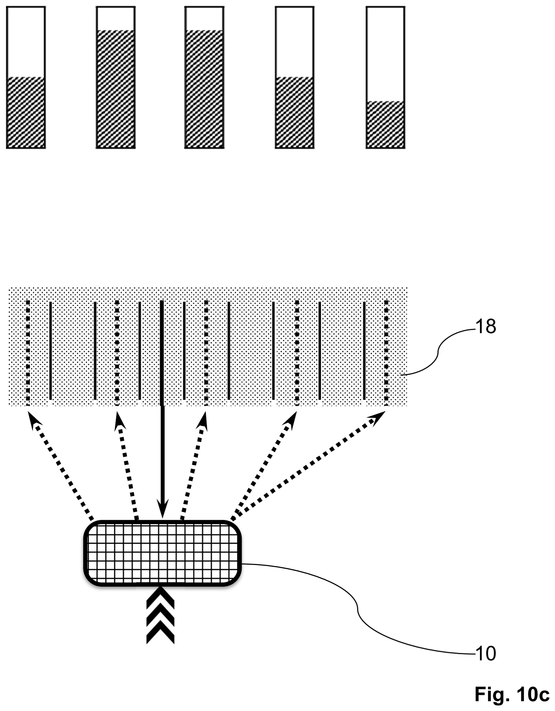

Es können auch Sendeeinheit und Empfangseinheit einen gemeinsamen Lichtleiterabschnitt verwenden, wenn diese Bauteile nicht gemeinsam in Form einer IR-Strecke betrieben werden. Deren Auswertung erfolgt dann mit einem Sende- bzw. Empfangselement, das einem anderen Lichtleiterteil zugeordnet ist. Weiterhin ist es eine Möglichkeit von vielen, Sender und Empfänger alternierend anzuordnen. Es können einem Empfänger z.B. mehrere Sender zwecks Auswertung zugeordnet werden. Bei mehreren Sendern und mehreren Empfängern macht z.B. ggf. eine Zuordnung aller Sender nacheinander zu jedem der Empfänger Sinn. Das Ansteuern der Sender geschieht in dem Fall nicht synchron, sondern nacheinander, um die Signalpegel den räumlich voneinander entfernt angeordneten Sendern zuordnen zu können. Weiterhin kann ein Sendeelement jeweils nacheinander mit mehreren Empfangselementen ausgewertet werden (synchron) - siehe Figuren 9a-9c und 10a-10c.

Ferner sieht eine weitere vorteilhafte Weiterbildung der erfindungsgemäßen Bedienvorrichtung vor, dass die Bedienvorrichtung derart ausgebildet und eingerichtet ist, dass in Abhängigkeit mindestens eines Signalpegels an der mindestens einen Empfangseinheit auf Basis der mindestens einen Sendeeinheit eine vorher festgelegte Bedienung der Bedienvorrichtung detektierbar ist, bevorzugt, dass in Abhängigkeit einer Mehrzahl von Signalpegeln an der als Mehrzahl von Empfangseinheiten ausgebildeten mindestens einen Empfangseinheit auf Basis der als Mehrzahl von Sendeeinheiten ausgebildeten mindestens einen Sendeeinheit eine vorher festgelegte Bedienung der Bedienvorrichtung detektierbar ist, besonders bevorzugt, dass die vorgenannte Bedienung als eine Geste des Benutzers ausgebildet ist. Auf diese Weise ist eine qualitativ hochwertige Erkennung einer Bedienung der erfindungsgemäßen Bedienvorrichtung durch den Benutzer sichergestellt. Dies gilt besonders für die bevorzugte Ausführungsform dieser Weiterbildung, da nicht lediglich ein einziger auf Basis einer einzigen Sendeeinheit basierender Signalpegel einer einzigen Empfangseinheit, sondern eine auf Basis einer Mehrzahl von Sendeeinheiten basierende Mehrzahl von Signalpegeln voneinander verschiedener Empfangseinheiten auswertbar sind. Die besonders bevorzugte Ausführungsform hat darüber hinaus den weiteren Vorteil, dass mittels der erfindungsgemäßen Bedienvorrichtung auch komplexe Bewegungsabläufe des Benutzers bei der Bedienung des Haushaltsgeräts auswertbar und nutzbar sind. Entsprechend ist eine Mehrzahl von voneinander verschiedenen Bedienungen, nämlich von Bediengesten des Benutzers, für die Bedienung des Haushaltsgeräts nutzbar.

Eine andere besonders vorteilhafte Weiterbildung der erfindungsgemäßen Bedienvorrichtung sieht vor, dass die Bedienvorrichtung derart ausgebildet und eingerichtet ist, dass die Bedienvorrichtung in einem ersten Betriebszustand der Bedienvorrichtung zur Bedienung des Haushaltsgeräts und in einem von dem ersten Betriebszustand verschiedenen zweiten Betriebszustand der Bedienvorrichtung zur optischen Anzeige von Haushaltsgeräteinformationen des Haushaltsgeräts nutzbar ist. Hierdurch ist die Funktionalität der erfindungsgemäßen Bedienvorrichtung auf alternative oder zusätzliche Art und Weise gesteigert. Die erfindungsgemäße Bedienvorrichtung ist nicht lediglich zur Bedienung, sondern auch zur Anzeige von Haushaltsgeräteinformationen und damit zur Information des Benutzers, zum Beispiel über dessen vorgenommene Bedienung, nutzbar.

Eine vorteilhafte Weiterbildung der letztgenannten Weiterbildung der erfindungsgemäßen Bedienvorrichtung sieht vor, dass mindestens einem, bevorzugt jedem, des mindestens einen a) benutzerseitigen oder b) benutzerseitigen und geräteseitigen Lichtleiters eine sichtbares Licht emittierende Lichtquelle der Bedienvorrichtung zwecks optischer Anzeige der Haushaltsgeräteinformationen des Haushaltsgeräts funktional zugeordnet ist. Auf diese Weise ist die vorgenannte Weiterbildung der erfindungsgemäßen Bedienvorrichtung auf konstruktiv und fertigungstechnisch sehr einfache und sehr platzsparende Art realisierbar.

Fünf Ausführungsbeispiele der Erfindung sind in den Zeichnungen rein schematisch dargestellt und werden nachfolgend näher beschrieben. Es zeigt
- Figur 1: ein Haushaltsgerät mit einem ersten Ausführungsbeispiel der erfindungsgemäßen Bedienvorrichtung in einem Einbauzustand, in perspektivischer Darstellung,
- Figur 2: das Haushaltsgerät analog zu der Fig. 1 mit einer vergrößerten Detaildarstellung im Bereich der erfindungsgemäßen Bedienvorrichtung,
- Figur 3a: das Haushaltsgerät gemäß der Fig. 1 in einer teilweisen, vergrößerten und transparenten perspektivischen Darstellung mit Blick auf die erfindungsgemäße Bedienvorrichtung,
- Figur 3b: das Haushaltsgerät gemäß der Fig. 1 in einer teilweisen, geschnittenen Seitenansicht im Bereich der erfindungsgemäßen Bedienvorrichtung,
- Figur 3c: das Haushaltsgerät in zu der Fig. 3b analoger Darstellung, während eines Bedienvorgangs,
- Figur 4a: das Haushaltsgerät mit einem zweiten Ausführungsbeispiel der erfindungsgemäßen Bedienvorrichtung in zu der Fig. 3a analoger Darstellung,
- Figur 4b: das Haushaltsgerät gemäß der Fig. 4a in zu der Fig. 3b analoger Darstellung,
- Figur 5a: das Haushaltsgerät mit einem dritten Ausführungsbeispiel der erfindungsgemäßen Bedienvorrichtung in zu der Fig. 3a analoger Darstellung,
- Figur 5b: das Haushaltsgerät gemäß der Fig. 5a in zu der Fig. 3b analoger Darstellung,
- Figur 5c: das Haushaltsgerät in zu der Fig. 5b analoger Darstellung, während eines Bedienvorgangs,
- Figur 6a: das Haushaltsgerät mit einem vierten Ausführungsbeispiel der erfindungsgemäßen Bedienvorrichtung in zu der Fig. 3a analoger Darstellung,
- Figur 6b: das Haushaltsgerät gemäß der Fig. 6a in zu der Fig. 3b analoger Darstellung,
- Figur 7: das Haushaltsgerät mit einem fünften Ausführungsbeispiel der erfindungsgemäßen Bedienvorrichtung in zu der Fig. 3b analoger Darstellung,
- Figur 8a: die einzelnen Signalwege gemäß der Fig. 3a in einer Draufsicht auf die benutzerseitigen Lichtleiter,
- Figur 8b: die einzelnen Signalwege gemäß der Fig. 5a in einer Draufsicht auf die benutzerseitigen Lichtleiter,
- Figur 9a-c: die einzelnen Signalwege analog zu den Fig. 8a oder 8b mit den korrespondierenden Signalpegeln der zugeordneten Empfangseinheiten, in drei Ansichten im Verlauf einer ersten Bewegung des Benutzers,
- Figur 10a-c: die einzelnen Signalwege analog zu den Fig. 8a oder 8b mit den korrespondierenden Signalpegeln der zugeordneten Empfangseinheiten, in drei Ansichten im Verlauf einer zweiten Bewegung des Benutzers,
- Figur 11a: die in einem einzigen Bauteil zusammengefassten benutzerseitigen Lichtleiter gemäß der Fig. 3a, in einer ersten perspektivischen Ansicht,
- Figur 11b: das Bauteil gemäß der Fig. 11a in einer zweiten perspektivischen Ansicht,
- Figur 12: die alternativ zu den Fig. 11a und 11b in einem einzigen Trägerbauteil zusammengefassten benutzerseitigen Lichtleiter, in einer perspektivischen Ansicht,
- Figur 13a: eine Variante der in einem einzigen Bauteil zusammengefassten benutzerseitigen Lichtleiter gemäß der Fig. 3a, in einer ersten perspektivischen Ansicht,
- Figur 13b: die Variante gemäß der Fig. 13a in einer zweiten perspektivischen Ansicht,
- Figur 14a: die einzelnen benutzerseitigen Lichtleiter gemäß der Fig. 5a, in einer ersten perspektivischen Ansicht und
- Figur 14b: eine Variante der einzelnen benutzerseitigen Lichtleiter gemäß der Fig. 5a, in einer perspektivischen Ansicht.

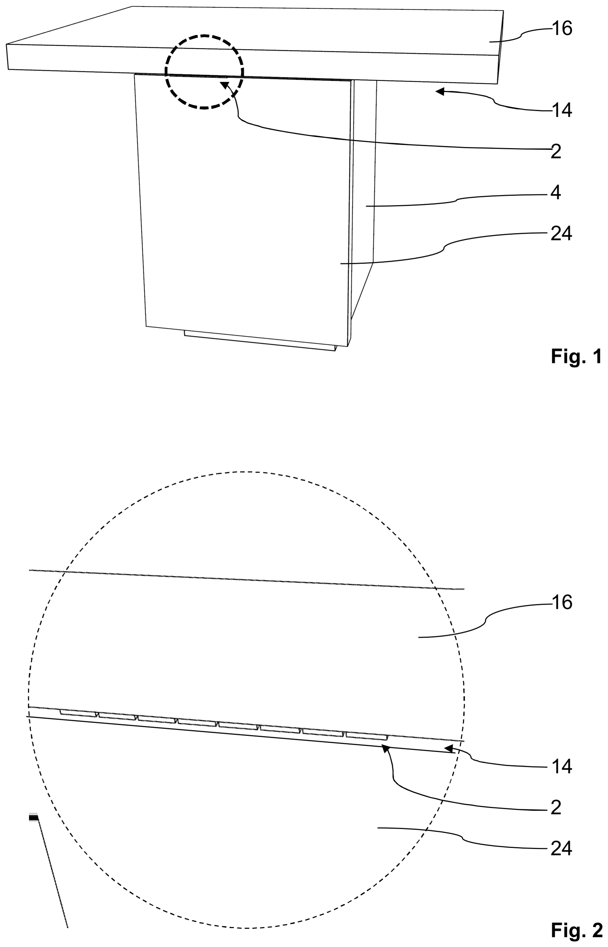

In den Fig. 1 bis 14b sind insgesamt fünf Ausführungsbeispiele der erfindungsgemäßen Bedienvorrichtung, teilweise in mehreren Varianten, rein exemplarisch dargestellt.

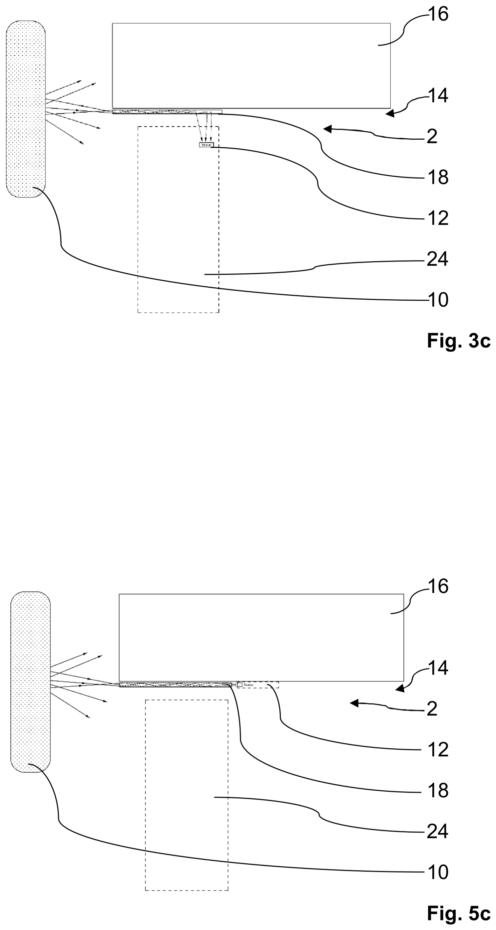

In den Fig. 1 bis 3c ist ein erstes Ausführungsbeispiel der erfindungsgemäßen Bedienvorrichtung gezeigt, wobei in der Fig. 2 der in der Fig. 1 eingekreiste Bereich vergrößert dargestellt ist. Die Bedienvorrichtung 2 für ein als vollintegrierter Geschirrspüler ausgebildetes Haushaltsgerät 4 ist als eine berührungslose Bedienvorrichtung mit mindestens einer optischen Sendeeinheit 6 zur Emission einer optischen Detektionsstrahlung, mindestens einer optischen Empfangseinheit 8 zum Empfang einer optischen Reflektionsstrahlung in Abhängigkeit einer Reflektion der Detektionsstrahlung an einem beispielsweise in der Fig. 3c lediglich teilweise dargestellten Benutzer 10 und mindestens einer mit der mindestens einen Sendeeinheit 6 und der mindestens einen Empfangseinheit 8 signalübertragend verbundenen Elektronikeinheit 12 zur Erzeugung der Detektionsstrahlung und zur Auswertung der Reflektionsstrahlung ausgebildet.

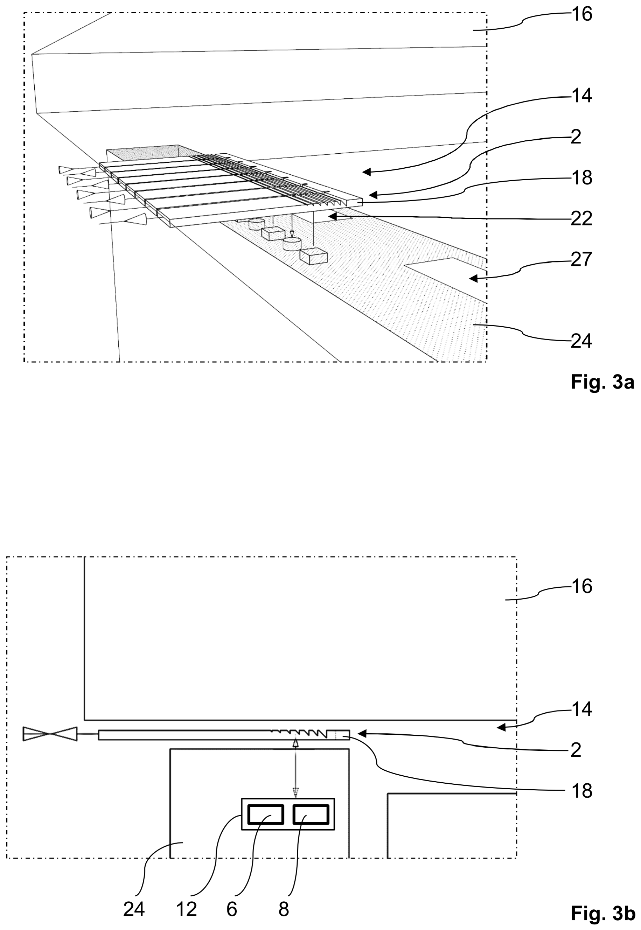

Erfindungsgemäß ist die Bedienvorrichtung 2 derart ausgebildet, dass die Bedienvorrichtung 2 durch einen Spalt 14, also eine Fuge, zwischen zwei Bauteilen des Haushaltsgeräts oder zwischen einerseits dem Haushaltsgerät 4 und andererseits einem direkt zu dem Haushaltsgerät 4 benachbarten Nachbarbauteil 16 einer baulichen Umgebung des Haushaltsgeräts 4 von dem Benutzer 10 benutzbar ist, wobei der Spalt 14 eine Spaltbreite von kleiner oder gleich 3 cm aufweist. Die Spaltbreite erstreckt sich in der Bildebene der Fig. 3b von oben nach unten. Beispielsweise kann der Spalt 14 eine Spaltbreite von kleiner oder gleich 25 mm, bevorzugt von kleiner oder gleich 10 mm, besonders bevorzugt von kleiner oder gleich 3 mm aufweisen. Das Nachbarbauteil 16 ist hier als eine Küchen-Arbeitsplatte ausgebildet.

Die Bedienvorrichtung 2 ist bei dem vorliegenden Ausführungsbeispiel zumindest teilweise als ein Teil des Haushaltsgeräts 4, bevorzugt vollständig als ein Teil des Haushaltsgeräts, ausgebildet. Ferner weist die Bedienvorrichtung 2 zusätzlich mindestens einen mit der mindestens einen Sendeeinheit 6 und der mindestens einen Empfangseinheit 8 signalübertragend verbundenen benutzerseitigen Lichtleiter 18 auf, wobei der mindestens eine benutzerseitige Lichtleiter 18 mindestens ein Lichtumlenkungselement aufweist, nämlich derart, dass dieses Lichtumlenkungselement als ein integraler Bestandteil dieses benutzerseitigen Lichtleiters 18 ausgebildet ist. Die Bedienvorrichtung 2 weist in Signalübertragungsrichtung zwischen der in dem Haushaltsgerät 4 integrierten Elektronikeinheit 12 und dem mindestens einen benutzerseitigen Lichtleiter 18 zusätzlich ein für die Detektionsstrahlung und die Reflektionsstrahlung durchlässiges Fenster 22 des Haushaltsgeräts 4 auf, wobei das Fenster 22 an einer Tür 24 des Haushaltsgeräts 4 zur Beladung und Entladung des Haushaltsgerät 4 angeordnet ist. Zwecks einer verbesserten Ästhetik weist die Tür 24 auf deren oberen Seite eine, bis auf das Fenster 22, blickdichte Blende oder einen blickdichten Blendenbereich auf. Das Fenster 22 ist hier keine tatsächliche Öffnung in der Tür 24, sondern lediglich ein für die vorgenannte Strahlung transparenter Bereich der Tür 24.

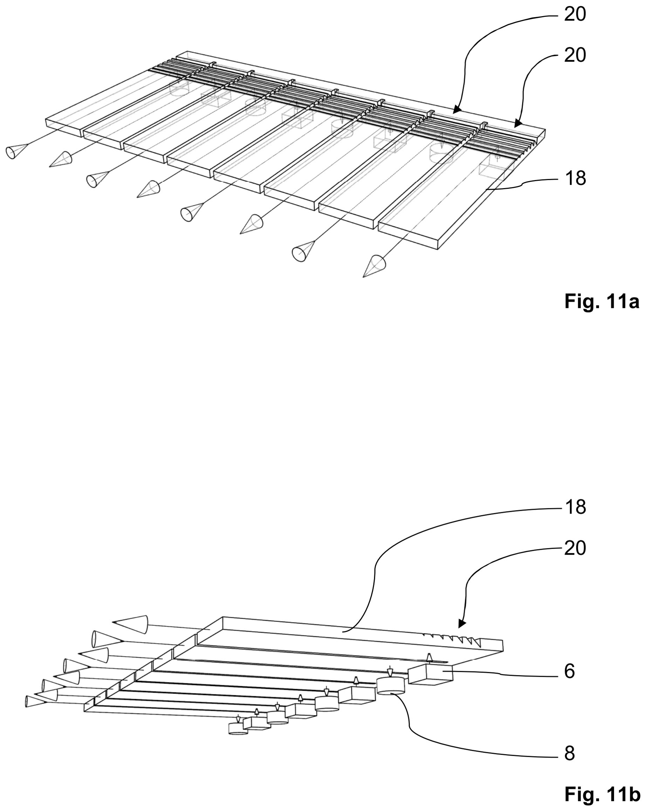

Wie aus der Fig. 3a ersichtlich ist, weist die Bedienvorrichtung 2 eine Mehrzahl von optischen Sendeeinheiten 6, von optischen Empfangseinheiten 8 und von benutzerseitigen Lichtleitern 18 auf, wobei die Bedienvorrichtung 2 derart ausgebildet ist, dass mittels der Bedienvorrichtung 2 eine Geste des Benutzers 10 detektierbar und auswertbar ist. Diese Mehrzahl von benutzerseitigen Lichtleitern 18 ist baulich als ein einziges Bauteil ausgebildet. Siehe hierzu beispielsweise die Fig. 3a und die Fig. 11a und 11b. Wie aus der Fig. 3a hervorgeht, ist hier jedem benutzerseitigen Lichtleiter 18 entweder eine Sendeeinheit 6 oder eine Empfangseinheit 8 funktional zugeordnet, wobei die zu den Sendeeinheiten 6 korrespondierenden Lichtleiter 18 und die zu den Empfangseinheiten 8 korrespondierenden Lichtleiter 18 alternierend aufeinander folgend nebeneinander angeordnet sind, und wobei direkt nebeneinander angeordnete Lichtleiter 18 ein Sende-/Empfangs-Funktionspaar der Bedienvorrichtung 2 ausbilden, nämlich derart, dass eine gleiche Anzahl von Sende- und Empfangseinheiten 6, 8 derart nebeneinander angeordnet sind. In den Fig. 11a und 11b sowie in anderen Figuren ist der jeweilige Strahlenverlauf durch die Lichtleiter 18 mit Pfeilen symbolisch dargestellt. Ferner sind in den Fig. 11a und 11b sowie in anderen Figuren die Sendeeinheiten 6 jeweils als Quader mit quadratischer Grundfläche und die Empfangseinheiten 8 sind jeweils als Zylinder mit kreisrunder Grundfläche symbolisiert. Im Unterschied dazu zeigen die Fig. 9a bis 9c und 10a bis 10c exemplarisch, dass auch Ausführungsformen denkbar sind, bei denen sich die Anzahl der Sendeeinheiten 6 und Empfangseinheiten 8 sowie der dazu korrespondierenden benutzerseitigen Lichtleiter 18 nicht entspricht.

Es sollte erwähnt werden, dass es in Anzahl und Anordnung von Sende- bzw. Empfangselementen sehr viele Kombinationsmöglichkeiten gibt. Weiterhin ist es sinnvoll, bei der Auswertung z.B. die Signale eines Senders mit mehreren Empfängern zu bewerten (und zu gewichten) bzw. die Signale mehrere Sender (räumlich voneinander entfernt) mit einem Empfänger zu bewerten. Die wechselnde Anordnung, die in verschiedenen Darstellungen verwendet wird, ist nur beispielhaft.

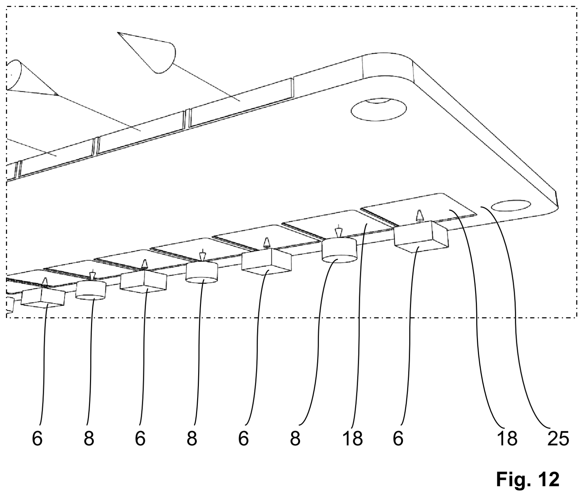

Ferner ist es möglich, dass die benutzerseitigen Lichtleiter 18 jeweils als einzelne in oder auf einem Trägerbauteil 25 der Bedienvorrichtung 2 angeordnete benutzerseitige Lichtleiter 18 ausgebildet sind, bevorzugt, dass das Trägerbauteil 25 gleichzeitig zur optischen Trennung der einzelnen benutzerseitigen Lichtleiter 18 voneinander ausgebildet ist. Siehe hierzu die Fig. 12. Diese Aufnahme der benutzerseitigen Lichtleiter 18 mittels des Trägerbauteils 25 ermöglicht durch schmale Trennstege des Trägerbauteils 25 zwischen den benutzerseitigen Lichtleitern 18 eine bessere optische Trennung, so dass störender und für die Funktion nachteiliger optischer Crosstalk wesentlich reduzierbar ist. Weiterhin sind die Montierbarkeit und die Robustheit eines solchen Aufbaus wesentlich gesteigert.

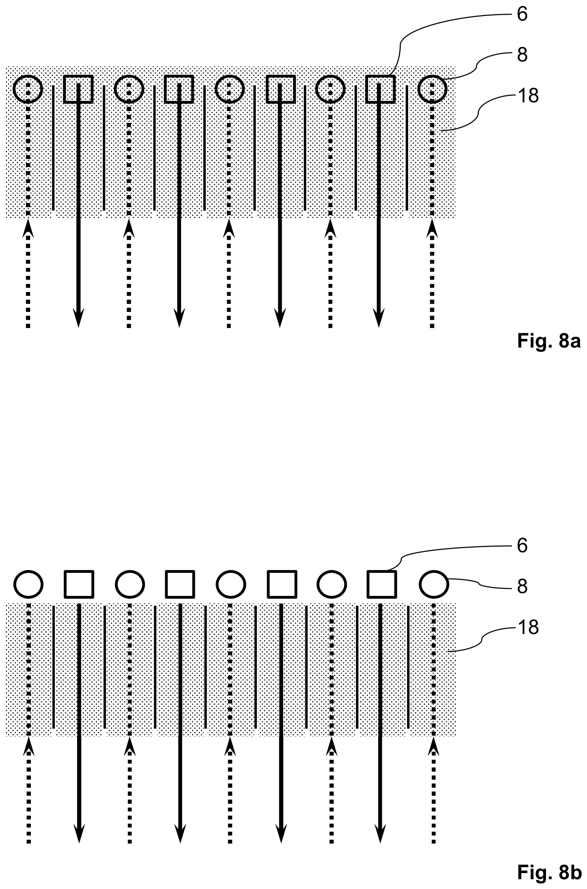

In den Fig. 8a und 8b ist jeweils die alternierende Anordnung von Sendestrecken, erkennbar an den durchgezogenen Pfeilen, und Empfängerstrecken, erkennbar an den unterbrochenen Pfeilen, dargestellt. Hierzu korrespondieren die oben bereits genannten Fig. 9a bis 9c und 10a bis 10c. Wie aus den Fig. 9a bis 9c und 10a bis 10c exemplarisch hervorgeht, ist die Bedienvorrichtung 2 derart ausgebildet und eingerichtet, dass in Abhängigkeit mindestens eines Signalpegels an der mindestens einen Empfangseinheit 8 auf Basis der mindestens einen Sendeeinheit 6 eine vorher festgelegte Bedienung der Bedienvorrichtung 2 detektierbar ist, wobei bei dem vorliegenden Ausführungsbeispiel in Abhängigkeit einer Mehrzahl von Signalpegeln an der als Mehrzahl von Empfangseinheiten 8 ausgebildeten mindestens einen Empfangseinheit 8 auf Basis der als Mehrzahl von Sendeeinheiten 6 ausgebildeten mindestens einen Sendeeinheit 6 eine vorher festgelegte Bedienung der Bedienvorrichtung 2 detektierbar ist. Bei der vorgenannten Bedienung handelt es sich zum Beispiel um eine als eine Geste des Benutzers 10 ausgebildete Bedienung. So kann der Benutzer 10 beispielsweise mit einem Finger, wie in den Fig. 9a bis 9c dargestellt, im Wesentlichen im gleichen Abstand zu der Fuge, also dem beispielsweise aus der Fig. 2 ersichtlichen Spalt 14, in der jeweiligen Bildebene der Fig. 9a bis 9c von links nach rechts streichen. Ein anderes Beispiel für eine Geste des Benutzers 10 ist in den Fig. 10a bis 10c dargestellt, wobei der Benutzer 10 beispielsweise einen Finger in der jeweiligen Bildebene der Fig. 10a bis 10c von unten nach oben in Richtung der Fuge, also auf den beispielsweise in der Fig. 2 dargestellten Spalt 14 zu, bewegt. In den Fig. 9a bis 9c und 10a bis 10c ist jeweils der zu jeder Empfangseinheit 8 korrespondierende Signalpegel in der jeweiligen Bildebene oberhalb des zugeordneten Lichtleiters 18 symbolisch als Säule dargestellt, wobei in diesen Beispielen, der Übersichtlichkeit wegen, lediglich eine der Sendeeinheiten 6 sendet und alle Empfangseinheiten 8 empfangen. Selbstverständlich ist es auch denkbar, dass eine andere Sendeeinheit 6, mehrere Sendeeinheiten 6 oder alle Sendeeinheiten 6 senden.

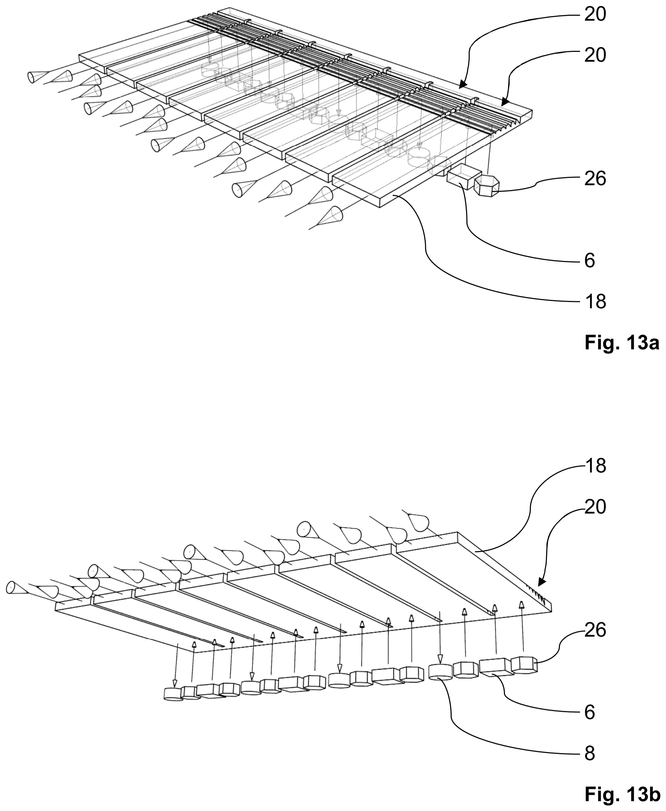

Darüber hinaus ist die Bedienvorrichtung 2 in einer Variante des ersten Ausführungsbeispiels derart ausgebildet und eingerichtet, dass die Bedienvorrichtung 2 in einem ersten Betriebszustand der Bedienvorrichtung 2 zur Bedienung des Haushaltsgeräts 4 und in einem von dem ersten Betriebszustand verschiedenen zweiten Betriebszustand der Bedienvorrichtung 2 zur optischen Anzeige von Haushaltsgeräteinformationen des Haushaltsgeräts 4 nutzbar ist. Der erste Betriebszustand wurde oben bereits erläutert. Der zweite Betriebszustand ist aus den Fig. 13a und 13b ersichtlich, wobei jedem benutzerseitigen Lichtleiter 18 neben der korrespondierenden Sende- oder Empfangseinheit 6, 8 zusätzlich eine mit der Elektronikeinheit 12 signalübertragend verbundene und sichtbares Licht emittierende Lichtquelle 26, beispielsweise eine LED, zugeordnet ist. Die Lichtquellen 26 sind in den Fig. 13a und 13b sowie in anderen Figuren jeweils als ein Sechseckprisma mit einer sechseckigen Grundfläche symbolisiert. Entsprechend wäre es nicht zwingend erforderlich, dass das Haushaltsgerät 4 eine zusätzliche Anzeigevorrichtung zur Anzeige von Haushaltsgeräteinformationen aufweist. Jedoch weist das Haushaltsgerät 4 hier eine nicht dargestellte zusätzliche Anzeigevorrichtung zur Anzeige von Haushaltsgeräteinformationen auf, wobei die zusätzliche Anzeigevorrichtung hinter einem Fenster 27 in der Tür 24 angeordnet ist. Das Fenster 27 ist, zumindest in einem Anzeigezustand der vorgenannten Anzeigevorrichtung, für sichtbares Licht durchlässig ausgebildet. Bei dem Fenster 27 handelt es sich wiederum nicht um eine tatsächliche Öffnung in der Tür 24, sondern lediglich um einen für sichtbares Licht transparenten Bereich der Tür 24. Die Anzeigevorrichtung ist zum Beispiel als ein Display ausgeführt. Ferner kann es vorgesehen sein, dass diese zusätzliche Anzeigevorrichtung als eine kombinierte Bedien- und Anzeigevorrichtung ausgebildet ist. Entsprechend wäre eine Bedienung des Haushaltsgeräts 4, zum Beispiel im geöffneten Zustand der Tür 24, also bei in einer Öffnungslage befindlicher Tür 24, auch alternativ mit dieser Bedien- und Anzeigevorrichtung möglich.

Die Bedienvorrichtung 2 basiert somit auf einer sehr flachen und somit platzsparenden Lichtleiterlösung, die eine Nutzung der naturgemäß vorhandenen Fugen zwischen dem Haushaltsgerät 4 und angrenzenden Nachbarbauteilen 16, wie Möbelteilen und Arbeitsplatten, ermöglicht. Für die Auswertung ist die Nutzung des infraroten Wellenlängenbereichs sehr vorteilhaft; jedoch sind auch andere Wellenlängenbereiche, wie sichtbares Licht oder UV-Strahlung, ebenfalls möglich. Eine sehr einfache Form der Bedienvorrichtung 2 ist die Kombination einer jeweiligen Sendeeinheit 6, zum Beispiel einer IR-Diode, mit einer zugeordneten Empfängereinheit 8, zum Beispiel einer Photodiode oder einem Phototransistor. Wie bei einer klassischen Reflex-Lichtschranke wird dabei die von der Sendeeinheit 6 abgestrahlte Strahlung an einem im Erfassungsbereich der jeweiligen Empfangseinheit 8 befindlichen Objekt, also beispielsweise einem Finger, einer Hand oder dem Rumpf des Benutzers 10, anteilig reflektiert und zur Empfangseinheit 8 geleitet. Je nach dem an der jeweiligen Empfangseinheit 8 anliegenden Signalpegel kann dann eine nachfolgende Auswertung in der Elektronikeinheit 12 erfolgen. Die Verwendung von mehreren Sendeeinheiten 6 und mehreren Empfangseinheiten 8 hat den Vorteil, dass sich auch dynamische Ereignisse, also Bewegungs-Ereignisse, im Erfassungsbereich hinsichtlich Richtung, Geschwindigkeit und dergleichen auswerten lassen. Die sendenden sowie die empfangenden Bauteile 6, 8 und benutzerseitigen Lichtleiter 18 sollten dabei möglichst voneinander entkoppelt sein, so dass der Anteil der an der jeweiligen Empfangseinheit 8 ankommenden Strahlung, ohne dass sich ein reflektierendes Objekt im Erfassungsbereich dieser Empfangseinheit 8 befindet, möglichst gering ist. Der sogenannte Crosstalk soll also möglichst minimiert sein. Es können sowohl gerade oder leicht gebogene Lichtleiter Verwendung finden, bei denen der optische Weg, nämlich der jeweilige Signalweg, ohne zusätzliche Umlenkungen von einem Ende zum anderen Ende durch den Lichtleiter hindurch verläuft. Jedoch sind auch, wie bei dem vorliegenden Ausführungsbeispiel, komplexere Lichtleitergeometrien bzw. Kombinationen mehrerer Lichtleitergeometrien, die eine Umlenkung des optischen Weges, zum Beispiel um 90°, ermöglichen, denkbar. Eine Umlenkung oder Lichtführung kann bei dem jeweiligen Lichtleiter durch verschiedenste optisch wirksame Strukturen, auch Mikrostrukturen, erreicht werden. Weiterhin können Oberflächenstrukturen, die eine Lichtbrechung oder Lichtbeugung zur Folge haben, eine vorteilhafte Lichtführung ermöglichen. Der Einfachheit halber wird die Umlenkung hier beispielhaft und somit stellvertretend für weitere Lösungen auf Basis spiegelnder Keilstrukturen/Prismenstrukturen beschrieben. Besonders vorteilhaft ist die Verwendung eines Aufbaukonzeptes, bei dem sich die Sende- und Empfangseinheiten, wie nachfolgend noch näher erläutert, in oder unter einem im Bedienbereich des Haushaltsgerätes verbauten Display befinden, weil dieses eine sehr vielseitige Bedienschnittstelle ermöglicht, ohne dass ein zusätzliches optisches Fenster oder eine tatsächliche Öffnung für die optische Strecke, nämlich den jeweiligen Signalweg, in einer Blende oder einer Blendenbedruckung, zum Beispiel der Tür 24 des Haushaltsgeräts 4, erforderlich ist. Weiterhin vorteilhaft ist die Kombination der Lichtleiter 18 mit den Lichtquellen 26. Auf diese Weise lässt sich bei lediglich geringen Mehrkosten eine in deren ausgeschalteten Zustand nahezu unsichtbare, mehrstufige Anzeige für das Haushaltsgerät 4 realisieren, das ansonsten unter Umständen über keinerlei weitere Anzeigemöglichkeit verfügt. Die Auswertung von optoelektronischen Sensoren, zum Beispiel von IR-Reflex-Sensorsystemen, ist grundsätzlich bekannt und wird deshalb nicht näher beschrieben. Abweichend von dem vollintegrierten Haushalts-Geschirrspüler des vorliegenden Ausführungsbeispiels ist eine Nutzung der Erfindung gleichermaßen für eine Vielzahl von anderen Geräten, beispielsweise anderen Haushaltsgeräten, möglich. Die Anordnung der erfindungsgemäßen Bedienvorrichtung gemäß dem vorliegenden Ausführungsbeispiel ist rein exemplarisch waagerecht an der oberen Kante des Haushaltsgeräts 4 ausgeführt. Die Erfindung kann jedoch gleichermaßen an jeder anderen Fuge des Geräts oder des Geräts mit einem Nachbarbauteil der baulichen Umgebung erfolgen. Die Ausführung der Lichtleiter 18 ist nicht auf rechteckige Querschnitte beschränkt. Stattdessen können auch davon abweichende Geometrien, also runde, ovale, drei- oder mehreckige Querschnitte, entsprechend umgesetzt werden. Auch ist die Anzahl der Lichtleiter 18 lediglich beispielhaft.

Nachfolgend werden vier weitere Ausführungsbeispiele näher erläutert. Gleiche oder gleichwirkende Bauteile sind mit den gleichen Bezugszeichen bezeichnet. Ferner werden diese Ausführungsbeispiele lediglich im Umfang der Unterschiede zu den vorhergenannten Ausführungsbeispielen, insbesondere zu dem oben umfangreich beschriebenen ersten Ausführungsbeispiel, erläutert. Ansonsten kann auf die vorgenannten Ausführungsbeispiele, insbesondere auf das erste Ausführungsbeispiel, verwiesen werden.

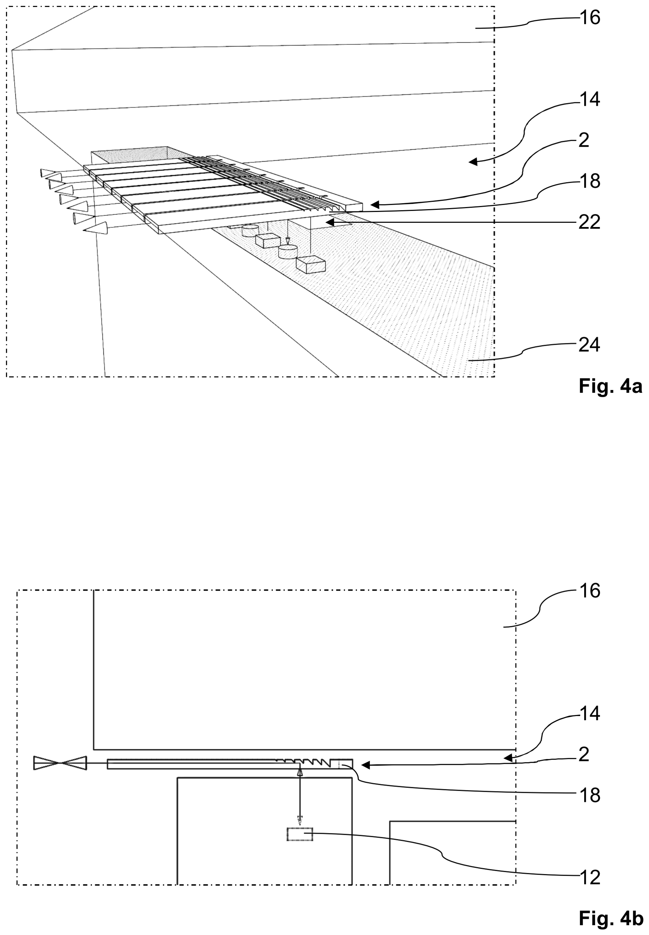

In den Fig. 4a und 4b ist ein zweites Ausführungsbeispiel der erfindungsgemäßen Bedieneinheit dargestellt. Im Unterschied zu dem ersten Ausführungsbeispiel weist das zweite Ausführungsbeispiel kein mit der Anzeigevorrichtung des ersten Ausführungsbeispiels vergleichbares separates Display auf. Das zweite Ausführungsbeispiel verfügt also lediglich über das Fenster 22 hinter dem in der Tür 24 ein als Anzeigevorrichtung oder als kombinierte Bedien- und Anzeigevorrichtung ausgebildetes Display angeordnet ist. Das Display ist nicht dargestellt und kann ähnlich dem Display hinter dem Fenster 27 des ersten Ausführungsbeispiels ausgeführt sein. Das Fenster 22 ist hier also gleichzeitig für eine Anzeigevorrichtung des Haushaltsgeräts 4 zur optischen Anzeige von Haushaltsgeräteinformationen geeignet ausgebildet.

Die Sende- und Empfangseinheiten 6, 8 sind in dem oder unterhalb des im oberen Bereich der Tür 24 integrierten Displays angeordnet. Zu diesem Zweck ist der Aufbau des verwendeten Displays in der Art modifiziert, dass die Strahlung der Sensorstrecke im dargestellten geschlossenen Zustand der Tür 24 möglichst ungehindert durch das Display, also den Displayaufbau, hindurchstrahlen kann. Eine diffuse Streuung sollte in dieser Nutzungsphase, also in dem ersten Betriebszustand, nach Möglichkeit reduziert werden. Realisiert werden kann dies zum Beispiel durch die Nutzung elektrochromer Schichten oder ähnlich wirkender Elemente, die sich je nach Nutzungsphase entweder transparent, bei geschlossener Tür 24, so dass die Sensorstrecke möglichst ungehindert durch das Display hindurchstrahlt, oder diffus streuend, bei geöffneter Tür 24, so dass ein Displaybacklight den Anzeigebereich der Anzeigevorrichtung homogen hinterleuchtet, ansteuern lassen. Weiterhin möglich ist die Nutzung von Schichten, zum Beispiel von Folien, die im Wellenlängenbereich sichtbaren Lichts diffus streuend wirken und für das Spektrum der IR-Strahlung, also im Bereich der Sensorstrecke, nämlich des Signalwegs, jedoch weitestgehend transparent wirken.

Ansonsten kann auf die obigen Ausführungen zu dem ersten Ausführungsbeispiel verwiesen werden. In einer Variante des zweiten Ausführungsbeispiels kann es vorgesehen sein, dass hinter dem Fenster 22, also in der Tür 24, keine Anzeigevorrichtung und keine kombinierte Bedien- und Anzeigevorrichtung angeordnet ist.

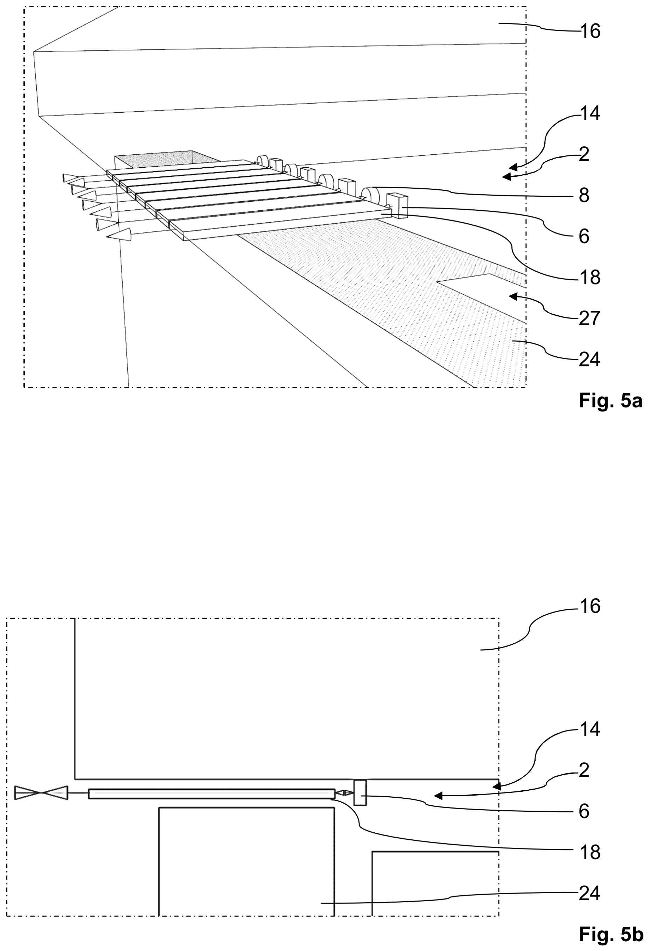

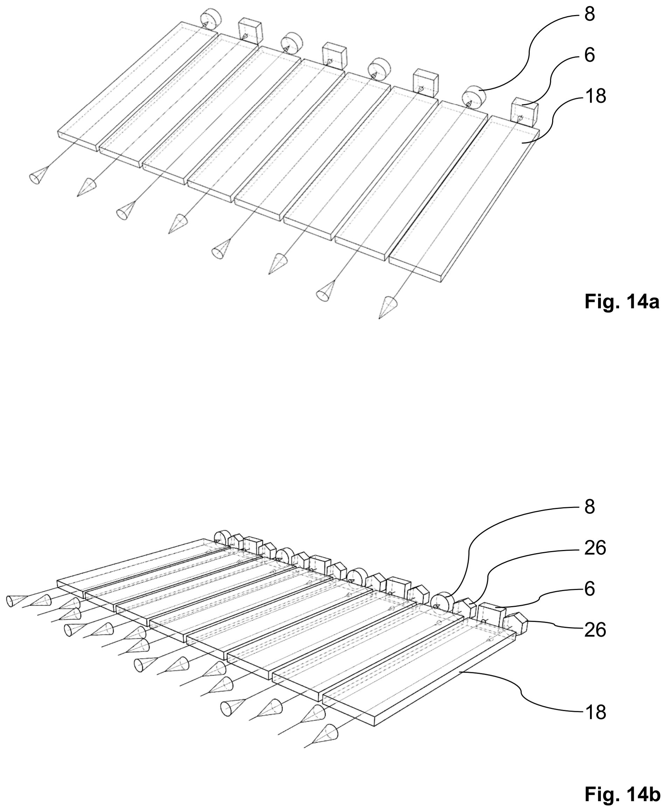

In den Fig. 5a bis 5c ist ein drittes Ausführungsbeispiel der erfindungsgemäßen Bedieneinheit dargestellt. Im Unterschied zu den ersten beiden Ausführungsbeispielen ist die Bedieneinheit 2 hier nicht zumindest teilweise integraler Bestandteil der Tür 24. Stattdessen ist die Bedieneinheit 2 bei dem vorliegenden Ausführungsbeispiel unabhängig von der Tür 24 beispielsweise zumindest teilweise an oder in dem Haushaltsgerät 4 angeordnet. Eine erforderliche stromleitende Verbindung zu dem Haushaltsgerät 4 kann dabei zum Beispiel galvanisch oder induktiv erfolgen. Da die Bedieneinheit 2 auf die oben erläuterte Art und Weise unabhängig von der Tür 24 ist, ist eine Nutzung der Bedieneinheit 2 bei dem vorliegenden Ausführungsbeispiel sowohl in der dargestellten Schließlage der Tür 24 wie auch in einer nicht dargestellten Öffnungslage der Tür 24, ohne die engen technischen Grenzen des ersten und des zweiten Ausführungsbeispiels, möglich. Der zweite Betriebszustand ist, analog zu den Fig. 13a und 13b des ersten Ausführungsbeispiels, aus den Fig. 14a und 14b ersichtlich, wobei in der Variante gemäß der Fig. 14b jedem benutzerseitigen Lichtleiter 18 neben der korrespondierenden Sende- oder Empfangseinheit 6, 8 zusätzlich eine mit der Elektronikeinheit 12 signalübertragend verbundene und sichtbares Licht emittierende Lichtquelle 26, beispielsweise eine LED, zugeordnet ist. Ansonsten kann auf die obigen Ausführungen zu dem ersten Ausführungsbeispiel verwiesen werden.

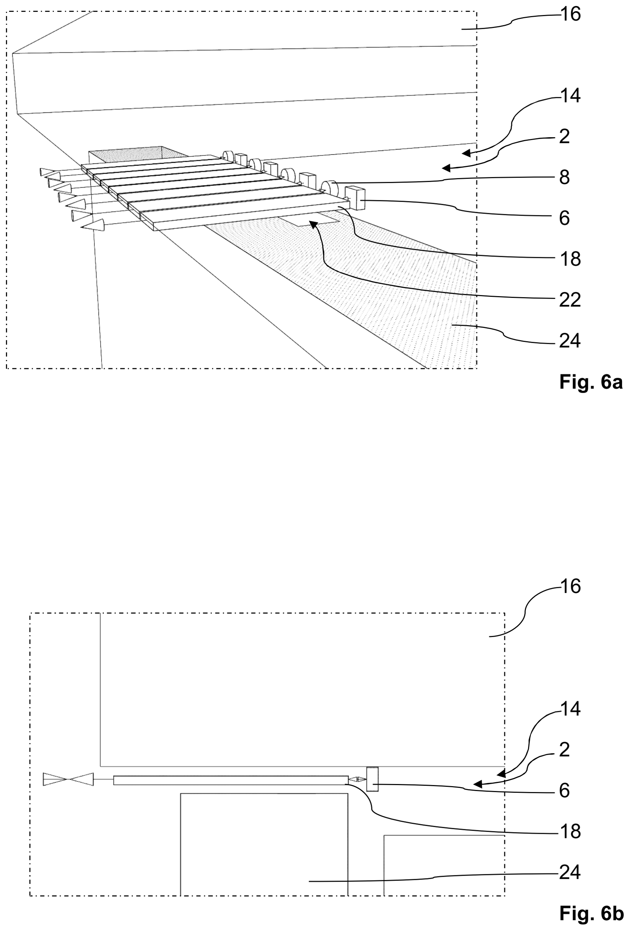

Das in den Fig. 6a und 6b dargestellte vierte Ausführungsbeispiel der erfindungsgemäßen Bedieneinheit entspricht, bis auf das hier nicht vorhandene Fenster 27, im Wesentlichen dem dritten Ausführungsbeispiel. Ansonsten kann auf die Ausführungen zu dem zweiten Ausführungsbeispiel verwiesen werden.

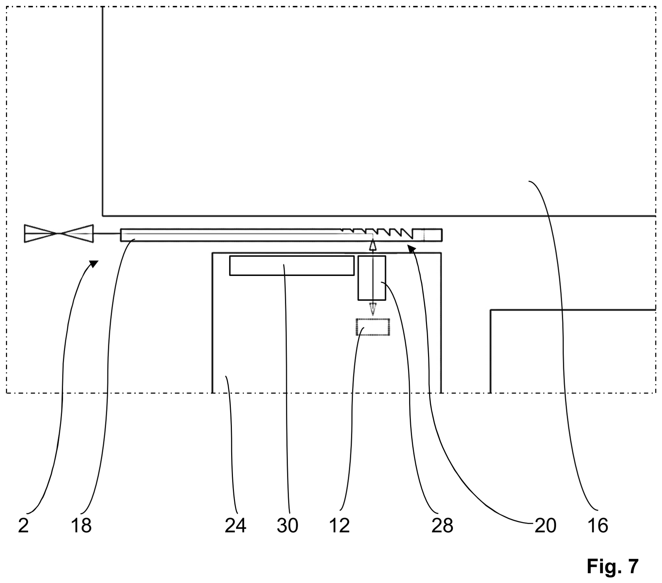

In der Fig. 7 ist ein fünftes Ausführungsbeispiel der erfindungsgemäßen Bedieneinheit dargestellt. Dieses fünfte Ausführungsbeispiel ist ähnlich zu dem ersten und zweiten Ausführungsbeispiel, jedoch ist hier jedem benutzerseitigen Lichtleiter 18 ein von diesem benutzerseitigen Lichtleiter 18 separater geräteseitiger Lichtleiter 28 der Bedienvorrichtung 2 zwecks Emission der Detektionsstrahlung und Empfang der Reflektionsstrahlung mittels der in dem Haushaltsgerät 4 integrierten Elektronikeinheit 12 funktional zugeordnet, wobei dieser geräteseitige Lichtleiter 28 an oder in dem Haushaltsgerät 4 angeordnet ist. Die den benutzerseitigen Lichtleitern 18 zugeordneten geräteseitigen Lichtleiter 28 können beispielsweise, wie in der Fig. 7 dargestellt, hinter dem Fenster 22 einer blickdichten Blende oder einem blickdichten Blendenbereich in der Tür 24 und unmittelbar benachbart zu einem als Anzeigeeinheit oder als eine Anzeige- und Bedieneinheit ausgebildeten Display 30 angeordnet sein. Somit braucht es lediglich ein einziges Fenster 22, hinter dem einerseits das Display 30 und davon separat andererseits die geräteseitigen Lichtleiter 28 angeordnet sind. Bei diesem Ausführungsbeispiel verläuft der Weg für die Detektionsstrahlung und die Reflektionsstrahlung nicht durch das Display 30 hindurch und nicht durch zusätzliche Fenster in der Blende oder von deren Bedruckung, sondern durch die neben dem Display 30 angeordneten geräteseitigen Lichtleiter 28. Die geräteseitigen Lichtleiter 28 nutzen entsprechend das Fenster 22 für das Display 30 in der Blende oder deren Bedruckung mit für die optische Strecke aus. Um die geräteseitigen Lichtleiter 28 zu kaschieren, also zumindest teilweise optisch zu verdecken, kann der Übergang des Displaybereichs des Fensters 22 für das Display 30 zu dem Blendenbereich der beispielsweise lediglich bedruckt ist, also lediglich über einen Dekordruck verfügt, mit einem dunkel eingefärbten, transparenten Lasurdruck bedruckt werden. Für den Benutzer sind die Bedien- und Anzeigemöglichkeiten analog zu den vorgenannten vier Ausführungsbeispielen. Jedoch ist die Erfindung mittels dieser Ausführungsform sehr kostengünstig realisierbar, da zum Beispiel das Display 30, anders als bei technischen Lösungen, bei denen die Detektionsstrahlung und die Reflektionsstrahlung in das Display 30 eingeleitet oder durch das Display 30 hindurchgeleitet wird, nicht angepasst werden müsste.

Die Bedienvorrichtung 2 des fünften Ausführungsbeispiels weist eine Mehrzahl von optischen Sendeeinheiten 6, von optischen Empfangseinheiten 8 und von benutzerseitigen und von geräteseitigen Lichtleitern 18, 28 auf, wobei die Bedienvorrichtung 2 derart ausgebildet ist, dass mittels der Bedienvorrichtung 2 eine Geste des Benutzers 10 detektierbar und auswertbar ist. Diese Mehrzahl einerseits von benutzerseitigen und andererseits von geräteseitigen Lichtleitern 18, 28 ist baulich, analog zu den vorgenannten vier Ausführungsbeispielen, jeweils zum Beispiel als ein einziges Bauteil oder als jeweils einzelne in oder auf einem Trägerbauteil der Bedienvorrichtung angeordnete einerseits benutzerseitige und andererseits geräteseitige Lichtleiter 18, 28 ausgebildet, wobei das jeweilige Trägerbauteil vorzugsweise gleichzeitig zur optischen Trennung einerseits der einzelnen benutzerseitigen und andererseits der einzelnen geräteseitigen Lichtleiter 18, 28 voneinander ausgebildet ist. Ferner ist jedem benutzerseitigen und geräteseitigen Lichtleiter 18, 28 entweder eine Sendeeinheit 6 oder eine Empfangseinheit 8 funktional zugeordnet, wobei die zu den Sendeeinheiten 6 korrespondierenden Lichtleiter 18, 28 und die zu den Empfangseinheiten 8 korrespondierenden Lichtleiter 18, 28 alternierend aufeinander folgend nebeneinander angeordnet sind, bevorzugt, dass direkt nebeneinander angeordnete Lichtleiter 18, 28 ein Sende-/Empfangs-Funktionspaar der Bedienvorrichtung 2 ausbilden, besonders bevorzugt, dass eine gleiche Anzahl von Sende- und Empfangseinheiten 6, 8 derart nebeneinander angeordnet sind. Darüber hinaus kann jedem des mindestens einen benutzerseitigen und geräteseitigen Lichtleiters 18, 28, analog zu den vorgenannten vier Ausführungsbeispielen, eine sichtbares Licht emittierende Lichtquelle der Bedienvorrichtung 2 zwecks optischer Anzeige von Haushaltsgeräteinformationen des Haushaltsgeräts 4 funktional zugeordnet sein.

Aufgrund der erfindungsgemäßen Ausbildung der Bedienvorrichtung 2 gemäß der beschriebenen fünf Ausführungsbeispielen, mit deren Varianten, ist somit eine einfache Interaktion des Benutzers 10 mit dem die Bedienvorrichtung 2 aufweisenden Haushaltsgerät 4 auf konstruktiv und fertigungstechnisch sehr einfache Art und Weise ermöglicht. Die Bedienvorrichtung 2 ist für einen sehr platzsparenden Einsatz geeignet ausgebildet, so dass naturgemäß vorhandene Fugen zwischen dem mit der Bedienvorrichtung 2 ausgestatteten Haushaltsgerät 4 und angrenzenden Nachbarbauteilen 16, beispielsweise von Möbelteilen wie Arbeitsplatten oder dergleichen, für eine Bedienung des Haushaltsgeräts 4 nutzbar sind. Ferner lässt sich die Bedienvorrichtung 2 in unterschiedlichen Einbausituationen, wie zum Beispiel Möbel- oder Küchenumgebungen, ohne eine individuelle Anpassung von Möbel- oder Anbauteilen integrieren. Um den Benutzer 10 nicht hinsichtlich der Wahl seiner bevorzugten Möbelfronten oder deren charakteristischen Eigenschaften, beispielsweise Materialien und Beschichtungen, einzuschränken, ist die Bedienvorrichtung 2 und damit das damit umsetzbare Bedienkonzept vollkommen unabhängig von den vorgenannten Rahmenbedingungen und Wünschen des Benutzers 10 einsetzbar. Auch lässt sich die Bedienvorrichtung 2 leicht in bereits vorhandene Aufbaukonzepte von Haushaltsgeräten integrieren, so dass auch bestehende Haushaltsgerätekonstruktionen ohne viel Aufwand in Konstruktion und Fertigung auf die Bedienvorrichtung 2 umrüstbar sind.

Die Erfindung ist nicht auf die vorliegenden Ausführungsbeispiele beschränkt. Siehe hierzu beispielsweise die diesbezüglichen Ausführungen in der Beschreibungseinleitung und die in dem konkreten Beschreibungsteil genannten alternativen und optionalen Merkmale. Beispielsweise kann die erfindungsgemäße Bedienvorrichtung nicht nur teilweise als ein Teil des Haushaltsgeräts, sondern vollständig als ein Teil des Haushaltsgeräts ausgebildet sein. Entsprechend kann die Erfindung auch vorteilhaft für Fugen, also Spalte, angewendet werden, die nicht zwischen dem Haushaltsgerät und einem Nachbarbauteil, sondern zwischen zwei Bauteilen des Haushaltsgeräts ausgebildet sind.

## Patentansprüche

1. Bedienvorrichtung (2) für ein Haushaltsgerät (4), wobei die Bedienvorrichtung (2) als eine berührungslose Bedienvorrichtung mit mindestens einer optischen Sendeeinheit (6) zur Emission einer optischen Detektionsstrahlung, mindestens einer optischen Empfangseinheit (8) zum Empfang einer optischen Reflektionsstrahlung in Abhängigkeit einer Reflektion der Detektionsstrahlung an einem Benutzer oder einem Objekt (10) und mindestens einer mit der mindestens einen Sendeeinheit (6) und der mindestens einen Empfangseinheit (8) signalübertragend verbundenen Elektronikeinheit (12) zur Erzeugung der Detektionsstrahlung und zur Auswertung der Reflektionsstrahlung ausgebildet ist, **dadurch gekennzeichnet, dass** die Bedienvorrichtung (2) derart ausgebildet ist, dass die Bedienvorrichtung (2) durch einen Spalt (14) zwischen zwei Bauteilen des Haushaltsgeräts oder zwischen einerseits dem Haushaltsgerät (4) und andererseits einem direkt zu dem Haushaltsgerät (4) benachbarten Nachbarbauteil (16) einer baulichen Umgebung des Haushaltsgeräts (4) von dem Benutzer (10) benutzbar ist, wobei der Spalt (14) eine Spaltbreite von kleiner oder gleich 3 cm aufweist.

2. Bedienvorrichtung (2) nach Anspruch 1, **dadurch gekennzeichnet, dass** der Spalt (14) eine Spaltbreite von kleiner oder gleich 25 mm, bevorzugt von kleiner oder gleich 10 mm, besonders bevorzugt von kleiner oder gleich 3 mm aufweist.

3. Bedienvorrichtung (2) nach Anspruch 1 oder 2, **dadurch gekennzeichnet, dass** die Bedienvorrichtung (2) zumindest teilweise als ein Teil des Haushaltsgeräts (4), bevorzugt vollständig als ein Teil des Haushaltsgeräts, ausgebildet ist.

4. Bedienvorrichtung (2) nach einem der Ansprüche 1 bis 3, **dadurch gekennzeichnet, dass** die Bedienvorrichtung (2) zusätzlich mindestens einen mit der mindestens einen Sendeeinheit (6) und der mindestens einen Empfangseinheit (8) signalübertragend verbundenen benutzerseitigen Lichtleiter (18) aufweist, bevorzugt, dass der mindestens eine benutzerseitige Lichtleiter (18) mindestens ein Lichtumlenkungselement (20) aufweist, besonders bevorzugt, dass dieses Lichtumlenkungselement (20) als ein integraler Bestandteil dieses benutzerseitigen Lichtleiters (18) ausgebildet ist.

5. Bedienvorrichtung (2) nach Anspruch 4, rückbezogen auf Anspruch 3, **dadurch gekennzeichnet, dass** jedem benutzerseitigen Lichtleiter (18) ein von diesem benutzerseitigen Lichtleiter (18) separater geräteseitiger Lichtleiter (28) der Bedienvorrichtung (2) zwecks Emission der Detektionsstrahlung und Empfang der Reflektionsstrahlung mittels der in dem Haushaltsgerät (4) integrierten Elektronikeinheit (12) funktional zugeordnet ist, wobei dieser geräteseitige Lichtleiter (28) an oder in dem Haushaltsgerät (4) angeordnet ist.

6. Bedienvorrichtung (2) nach Anspruch 4 oder 5, **dadurch gekennzeichnet, dass** die Bedienvorrichtung (2) in Signalübertragungsrichtung zwischen der in dem Haushaltsgerät (4) integrierten Elektronikeinheit (12) und dem mindestens einen benutzerseitigen Lichtleiter (18) zusätzlich ein für die Detektionsstrahlung und die Reflektionsstrahlung durchlässiges Fenster (22) des Haushaltsgeräts (4) aufweist, bevorzugt, dass das Fenster (22) an einer Tür (24) des Haushaltsgeräts (4) zur Beladung und Entladung des Haushaltsgeräts (2) angeordnet ist und/oder, dass das Fenster (22) gleichzeitig für eine Anzeigevorrichtung des Haushaltsgeräts (4) zur optischen Anzeige von Haushaltsgeräteinformationen geeignet ausgebildet ist.

7. Bedienvorrichtung (2) nach einem der Ansprüche 4 bis 6, **dadurch gekennzeichnet, dass** die Bedienvorrichtung (2) eine Mehrzahl von optischen Sendeeinheiten (6), von optischen Empfangseinheiten (8) und a) von benutzerseitigen Lichtleitern (18) oder b) von benutzerseitigen und von geräteseitigen Lichtleitern (18, 28) aufweist, wobei die Bedienvorrichtung (2) derart ausgebildet ist, dass mittels der Bedienvorrichtung (2) eine Geste des Benutzers (10) oder eine Annäherung / Bewegung eines Objektes (10) detektierbar und auswertbar ist.

8. Bedienvorrichtung (2) nach Anspruch 7, **dadurch gekennzeichnet, dass** diese Mehrzahl von a) benutzerseitigen oder b) einerseits von benutzerseitigen und andererseits von geräteseitigen Lichtleitern (18; 18, 28) baulich jeweils als ein einziges Bauteil oder als jeweils einzelne in oder auf einem Trägerbauteil (25) der Bedienvorrichtung (2) angeordnete a) benutzerseitige oder b) einerseits benutzerseitige und andererseits geräteseitige Lichtleiter (18; 18, 28) ausgebildet ist, bevorzugt, dass das jeweilige Trägerbauteil (25) gleichzeitig zur optischen Trennung der einzelnen a) benutzerseitigen oder b) einerseits der einzelnen benutzerseitigen und andererseits der einzelnen geräteseitigen Lichtleiter (18; 18, 28) voneinander ausgebildet ist.

9. Bedienvorrichtung (2) nach Anspruch 7 oder 8, **dadurch gekennzeichnet, dass** jedem a) benutzerseitigen oder b) benutzerseitigen und geräteseitigen Lichtleiter (18; 18, 28) entweder eine Sendeeinheit (6) oder eine Empfangseinheit (8) funktional zugeordnet ist, wobei die zu den Sendeeinheiten (6) korrespondierenden Lichtleiter (18; 18, 28) und die zu den Empfangseinheiten (8) korrespondierenden Lichtleiter (18; 18, 28) alternierend aufeinander folgend nebeneinander angeordnet sind, bevorzugt, dass direkt nebeneinander angeordnete Lichtleiter (18; 18, 28) ein Sende-/Empfangs-Funktionspaar der Bedienvorrichtung (2) ausbilden, besonders bevorzugt, dass eine gleiche Anzahl von Sende- und Empfangseinheiten (6, 8) derart nebeneinander angeordnet sind.

10. Bedienvorrichtung (2) nach einem der Ansprüche 1 bis 9, **dadurch gekennzeichnet, dass** die Bedienvorrichtung (2) derart ausgebildet und eingerichtet ist, dass in Abhängigkeit mindestens eines Signalpegels an der mindestens einen Empfangseinheit (8) auf Basis der mindestens einen Sendeeinheit (6) eine vorher festgelegte Bedienung der Bedienvorrichtung (2) detektierbar ist, bevorzugt, dass in Abhängigkeit einer Mehrzahl von Signalpegeln an der als Mehrzahl von Empfangseinheiten (8) ausgebildeten mindestens einen Empfangseinheit (8) auf Basis der als Mehrzahl von Sendeeinheiten (6) ausgebildeten mindestens einen Sendeeinheit (6) eine vorher festgelegte Bedienung der Bedienvorrichtung (2) detektierbar ist, besonders bevorzugt, dass die vorgenannte Bedienung als eine Geste des Benutzers (10) ausgebildet ist.

11. Bedienvorrichtung (2) nach einem der Ansprüche 1 bis 10, **dadurch gekennzeichnet, dass** die Bedienvorrichtung (2) derart ausgebildet und eingerichtet ist, dass die Bedienvorrichtung (2) in einem ersten Betriebszustand der Bedienvorrichtung (2) zur Bedienung des Haushaltsgeräts (4) und in einem von dem ersten Betriebszustand verschiedenen zweiten Betriebszustand der Bedienvorrichtung (2) zur optischen Anzeige von Haushaltsgeräteinformationen des Haushaltsgeräts (4) nutzbar ist.

12. Bedienvorrichtung (2) nach Anspruch 11, **dadurch gekennzeichnet, dass** mindestens einem, bevorzugt jedem, des mindestens einen a) benutzerseitigen oder b) benutzerseitigen und geräteseitigen Lichtleiters (18, 18, 28) eine oder mehrere sichtbares Licht emittierende Lichtquelle(n) (26) der Bedienvorrichtung (2) zwecks optischer Anzeige der Haushaltsgeräteinformationen des Haushaltsgeräts (4) funktional zugeordnet ist bzw. sind.
